# FASCICULE DE BREVET EUROPEEN

(11) **EP 2 949 621 B1**
(45) Date de publication et mention de la délivrance du brevet: **09.11.2016**
(21) Numéro de dépôt: 15169015.3
(22) Date de dépôt: 22.05.2015
(51) Int. Cl.: B81B 3/00

(54) **DISPOSITIF MICROELECTRONIQUE ET/OU NANOELECTRONIQUE CAPACITIF A COMPACITE AUGMENTEE**
Kapazitive mikro- und/ oder nanoelektronische Vorrichtung mit erhöhter Kompaktheit
Capacitive micro and/ or nanoelectronic device having increased compactness

(30) Priorité: 26.05.2014 FR 1454734
(43) Date de publication de la demande: 02.12.2015
(73) Titulaire: Commissariat à l'Énergie Atomique et aux Énergies Alternatives, 75015 Paris (FR)
(72) Inventeur: Robert, Philippe, 38000 GRENOBLE (FR); Joet, Loïc, 38000 GRENOBLE (FR)
(74) Mandataire: Brevalex

(56) Documents cités:
- EP-A2- 2 066 015
- WO-A1-2010/029516
- WO-A1-2011/003803

## Description

### DOMAINE TECHNIQUE ET ÉTAT DE LA TECHNIQUE ANTÉRIEURE

La présente invention se rapporte à un dispositif microélectronique et/ou nanoélectronique comportant une partie mobile et une partie fixe et des moyens capacitifs dont la capacité varie avec le déplacement relatif des parties mobile et fixe, le dispositif pouvant présenter une compacité augmentée.

La variation de capacité due au déplacement relatif des parties mobile et fixe peut servir à la détection du mouvement relatif entre une partie fixe et une partie mobile et est par exemple mise en oeuvre dans les systèmes microélectromécaniques ou MEMS (MicroElectroMechanical System) utilisés pour réaliser des capteurs tels que des accéléromètres, des gyromètres, des magnétomètres.

Les utilisations de capteurs MEMS capacitifs sont multiples. Ceux-ci sont par exemple utilisés dans l'automobile, dans le domaine grand public comme par exemple dans les téléphones portables, dans les jeux électroniques, dans l'aéronautique, le domaine médical,...

On cherche non seulement à réduire le coût de ces capteurs mais également à en réduire la taille, notamment dans l'automobile et dans le domaine grand public.

Un accéléromètre comporte une masse sismique reliée au substrat par le biais de poutres flexibles. Des doigts formant des électrodes sont solidaires de la masse sismique et sont interdigités avec des doigts formant des électrodes fixes par rapport au substrat. Les ensembles de doigts sont également appelés "peignes". Sous l'effet d'une accélération, la masse mobile se déplace dans le plan. Le déplacement relatif de masse sismique par rapport au substrat provoque un déplacement relatif entre les doigts interdigités, ce qui entraîne une variation d'entrefer et une variation de capacité entre les doigts fixes par rapport au substrat et les doigts fixes par rapport à la masse inertielle. La mesure d'accélération s'effectue par la mesure de cette variation de capacité.

De manière classique, les doigts s'étendent latéralement de part et d'autre de la masse inertielle. Cette configuration implique un encombrement important dans le plan.

Les gyromètres comportent au moins deux jeux de peignes capacitifs interdigités. Un premier jeu assure l'excitation d'un premier mode de résonance et un deuxième jeu assure la détection d'un second mode de vibration, orthogonal au premier, qui est induit par la force de Coriolis s'exerçant sur la ou les masses inertielles lorsque le capteur est soumis à une rotation.

Les peignes étant disposés tout autour de la masse inertielle, l'empreinte dans le plan est encore plus importante.

Afin de réduire cet encombrement, il a été envisagé d'augmenter l'épaisseur de la masse inertielle pour pouvoir réduire son empreinte dans le plan tout en conservant sa masse. Cependant cela a pour effet d'accroître l'entrefer des peignes interdigités afin de conserver le rapport de forme de la gravure dans le silicium. En effet, la gravure dans une épaisseur plus importante nécessite des ouvertures pour la gravure plus larges. Il en résulte une perte de sensibilité électrique du composant.

Le document EP 2 066 015 A2 traite de dispositifs qui présentent une masse sismique dans un premier plan et des électrodes dans un second plan afin de réduire l'encombrement de l'ensemble. Ce document divulgue un dispositif à élément mobile s'étendant suivant un plan donné comportant une première, une deuxième et une troisième couches s'étendant dans des plans parallèles au plan donné , la première couche formant un support, la deuxième couche comportant l'élément mobile. Ce dispositif comporte en outre des moyens capacitifs dont la capacité varie en fonction de la position relative de l'élément mobile par rapport au support, lesdits moyens capacitifs comportant une électrode mobile solidaire d'une des faces de l'élément mobile parallèle au plan donné et une électrode fixe par rapport au support, la troisième couche comprenant ladite électrode fixe et ladite électrode mobile, les électrodes fixe et mobile étant disposées au moins en partie dans un même plan parallèle au plan donné et au moins en partie au-dessus et/ou en dessous de l'élément mobile. Il a été proposé dans le document *"*Hewlett Packard's Seismic Grade MEMS Accelerometer" - B. Homeijer, D. Lazaroff, D. Milligan, R. Alley, J. Wu, M. Szepesi, B. Bicknell, Z. Zhang, R. Walmsley and P. Hartwell - IEEE MEMS, 2011 de disposer un premier jeu d'électrodes sous la masse inertielle solidaires de celle-ci, formant les électrodes mobiles, et de reporter par scellement l'autre jeu d'électrodes sur le capot, formant les électrodes fixes, en regard des électrodes mobiles. Le capot est scellé sur le substrat sur lequel est suspendue la masse inertielle. L'empreinte du capteur dans le plan est alors réduite. En revanche, l'entrefer entre les électrodes fixes et les électrodes mobiles est déterminé par l'épaisseur du scellement et non pas par une gravure profonde de la masse sismique. Il en résulte un entrefer important, par exemple très supérieur à 1 µm, ce qui limite la sensibilité électrique. En outre cet entrefer est mal contrôlé.

### EXPOSÉ DE L'INVENTION

C'est par conséquent un but de la présente invention d'offrir un dispositif capacitif comportant une partie mobile et une partie fixe, offrant une compacité dans le plan augmentée.

Le but de la présente invention énoncé ci-dessus est atteint par un dispositif comportant une partie mobile et une partie fixe, et des moyens capacitifs, la partie mobile comportant un élément mobile et au moins une électrode mobile sur sa face inférieure et/ou sa face supérieure, l'élément mobile et l'électrode mobile étant réalisées dans deux couches distinctes et la partie fixe comportant au moins une électrode fixe disposée par rapport à l'électrode mobile de sorte qu'un déplacement de la partie mobile provoque une variation d'entrefer, l'électrode fixe et l'électrode mobile étant réalisées dans la même couche, avantageusement simultanément.

L'élément mobile peut-être une masse sismique ou tout autre élément mécanique susceptible de se déplacer par rapport à la partie fixe.

On entend par "couche" une épaisseur de un ou plusieurs matériaux qui peut être obtenue soit en une seule étape soit en plusieurs étapes, la couche peut donc comporter différents matériaux.

L'encombrement du dispositif dans le plan est réduit.

Puisque les électrodes mobile et fixe sont réalisées dans une couche distincte de celle de l'élément mobile, la couche dans laquelle les électrodes mobile et fixe sont réalisées peut être avantageusement fine alors que celle de l'élément mobile peut être épaisse. Un élément mobile épais permet de réduire l'empreinte du dispositif dans le plan à niveau de précision constant. Lorsque la couche dans laquelle les électrodes fixe et mobile sont réalisées est fine, il est possible de réaliser un entrefer étroit, par exemple inférieur à 0,5 µm pour une couche de 10 µm, le rapport de forme est alors de 20. Un entrefer étroit permet de gagner très fortement en sensibilité électrique, et de densifier le nombre d'électrodes et d'accroître encore la sensibilité.

Puisque les électrodes fixe et mobile sont réalisées à partir de la même couche avantageusement simultanément, l'entrefer entre les électrodes peut être réalisé par gravure, ce qui permet un bon contrôle dimensionnel des entrefers.

En d'autres termes, on réalise séparément la partie mécanique et la partie détection de type capacitif de la partie mobile ce qui permet d'optimiser chacune des ces parties séparément. Avantageusement, on réalise les électrodes fixe et mobile de la partie de détection dans une épaisseur de matériau permettant de réaliser des entrefers étroits.

De manière avantageuse, les moyens capacitifs comportent plusieurs électrodes mobiles et plusieurs électrodes fixes.

De manière très avantageuse, les moyens capacitifs sont du type à variation d'entrefer présentant une plus sensibilité que ceux du type à variation de surface. Toutefois, pour les applications requérant un grand déplacement de l'élément mobile, les moyens peuvent être du type à variation de surface.

De manière également avantageuse, les moyens capacitifs sont du type peignes interdigités, ce qui permet de densifier le nombre d'électrodes.

La présente invention a alors pour objet un dispositif à élément mobile s'étendant suivant un plan donné comportant au moins une première, une deuxième et une troisième couches s'étendant dans des plans parallèles au plan donné, la première couche formant un support, la deuxième couche comportant tout ou partie de l'élément mobile et des moyens de suspension de l'élément mobile par rapport au support et la troisième couche comprenant tout ou partie des moyens capacitifs dont la capacité varie en fonction de la position relative de l'élément mobile par rapport au support, lesdits moyens capacitifs comportant au moins une électrode mobile solidaire d'une des faces de l'élément mobile parallèle au plan donné, et au moins une électrode fixe par rapport au support, les électrodes fixe et mobile étant disposées au moins en partie dans un même plan parallèle au plan donné et au moins en partie au-dessus et/ou en dessous de l'élément mobile.

De préférence, la deuxième couche présente une épaisseur supérieure à celle de la troisième couche, le rapport entre l'épaisseur de la deuxième couche et celle de la troisième couche étant avantageusement au moins égal à 2.

Le dispositif à élément mobile peut comporter au moins deux électrodes mobiles et deux électrodes fixes interdigitées.

La troisième couche peut avoir une épaisseur comprise entre quelques µm et quelques dizaines de µm.

Dans un exemple de réalisation, le dispositif à élément mobile comporte au moins deux électrodes mobiles et au moins deux électrodes fixes disposées de sorte que lorsque la capacité entre une électrode fixe et une électrode mobile augmente, la capacité entre l'autre électrode fixe et l'autre électrode mobile diminue afin de réaliser une mesure différentielle.

Selon une caractéristique additionnelle, l'électrode mobile peut être isolée électriquement de l'élément mobile, ledit dispositif comportant des moyens de connexion électrique de ladite électrode mobile. Le dispositif peut alors comporter plusieurs électrodes mobiles et plusieurs électrodes fixes, au moins une électrode mobile étant connectée électriquement de manière séparée des autres électrodes mobiles et/ou au moins une électrode fixe étant connectée électriquement de manière séparée des autres électrodes fixes.

Selon une caractéristique supplémentaire, l'électrode fixe peut être suspendue par rapport au support. Dans un exemple de réalisation, l'électrode fixe est suspendue par rapport au support entre une zone du support couverte par l'élément mobile et une zone du support non couverte par l'élément mobile.

En variante, l'électrode fixe est ancrée au support.

Le dispositif à l'élément mobile peut comporter des moyens capacitifs supplémentaires dont la capacité varie en fonction de la position relative de l'élément mobile et du support, lesdits moyens capacitifs supplémentaires étant disposés d'une part dans la deuxième couche sur au moins une première zone latérale de l'élément mobile et d'autre part sur une zone du support en regard.

Les moyens capacitifs supplémentaires peuvent être disposés d'une part dans la deuxième couche sur une deuxième zone latérale de l'élément mobile opposée à la première zone et d'autre part sur une zone du support en regard de la deuxième zone latérale.

La capacité des moyens capacitifs peut varier lorsque l'élément mobile se déplace selon une première direction et les moyens capacitifs supplémentaires sont disposés de sorte que leur capacité varie lorsque l'élément mobile se déplace selon une deuxième direction différente de la première direction, de préférence la deuxième direction étant orthogonale à la première direction.

Par exemple, les moyens capacitifs sont des moyens de détection de la position relative de la partie mobile et de la partie fixe.

Les moyens capacitifs et les moyens capacitifs supplémentaires peuvent former des moyens de détection de la position relative de l'élément mobile et du support, ou des moyens parmi les moyens capacitifs et les moyens capacitifs supplémentaires peuvent être des moyens de détection de la position relative de l'élément mobile et du support et les autres moyens sont soit des moyens d'actionnement de l'élément mobile par rapport au support soit des moyens pour générer une raideur électrostatique négative sur le dispositif.

La présente invention a également pour objet un système micro et/ou nanoélectronique comportant au moins un dispositif à élément mobile selon l'invention.

La présente invention a également pour objet un procédé de réalisation d'un dispositif à élément mobile selon l'invention, comportant les étapes :
A) Structuration d'une couche conductrice ou semi-conductrice formée sur un premier substrat de sorte à former simultanément au moins une électrode mobile et au moins une électrode fixe,
B) Assemblage du premier substrat et d'un deuxième substrat,
C) Structuration du premier substrat afin de définir l'élément mobile et les moyens de suspension,
D) Libération de l'élément mobile et libération de l'électrode fixe par rapport à l'électrode mobile.

Le procédé peut comporter préalablement à l'étape A) :
- la formation d'une couche sacrificielle sur le premier substrat,
- la structuration de la couche sacrificielle,
- la formation sur ladite couche sacrificielle structurée de la couche conductrice ou semi-conductrice.

L'étape B) peut être une étape de scellement par exemple par adhésion moléculaire.

L'étape D) peut avoir lieu par retrait au moins partielle de la couche sacrificielle, par exemple par gravure.

### BRÈVE DESCRIPTION DES DESSINS

La présente invention sera mieux comprise sur la base de la description qui va suivre et des dessins en annexe sur lesquels:
- la figure 1 est une vue de dessus du dispositif d'un exemple de réalisation d'un dispositif selon l'invention,
- la figure 2 est une vue en coupe transversale de la figure 1, sur laquelle les connexions électriques sont schématisées,
- la figure 3 est une vue en coupe transversale d'une variante de réalisation d'un dispositif selon l'invention,
- la figure 4A est une vue de dessus en transparence d'un autre exemple de réalisation d'un dispositif selon l'invention dans lequel la détection capacitive est différentielle et les électrodes fixes sont ancrées en dessous de l'élément mobile et en dehors de l'élément mobile,
- la figure 4B est une vue en coupe le long du plan B-B du dispositif de la figure 4A,
- la figure 5A est une vue de dessus en transparence d'un autre exemple de réalisation d'un dispositif selon l'invention dans lequel la détection capacitive est différentielle et les électrodes fixes sont ancrées sur le substrat,
- la figure 5B est une vue en coupe le long du plan B-B du dispositif de la figure 5A,
- la figure 6 est une vue en coupe transversale d'un autre exemple d'un dispositif selon l'invention,
- la figure 7 est une vue de dessus en transparence d'un autre exemple d'un dispositif selon l'invention adapté par exemple à la réalisation d'un gyromètre,
- la figure 8 est une vue de dessus en transparence d'un autre exemple de réalisation d'un dispositif selon l'invention dans laquelle la détection capacitive est par variation de surface,
- les figures 9A à 9H sont des représentations schématiques des éléments obtenus au cours de différentes étapes d'un exemple de procédé de réalisations selon l'invention,
- la figure 10 est une vue en coupe transversale d'un exemple de réalisation d'un dispositif selon l'invention à déplacement hors plan,
- la figure 11 est une vue de dessus du dispositif de la figure 10 dans lequel l'élément mobile est suspendu par des poutres sollicitées en torsion,
- la figure 12 est une vue de dessus du dispositif de la figure 10 dans lequel l'élément mobile est suspendu par des poutres sollicitées en flexion,
- la figure 13 est une vue en coupe transversale d'un autre exemple de réalisation d'un dispositif selon l'invention à déplacement hors plan muni de trous dans l'élément mobile en vue de sa libération.

### EXPOSÉ DÉTAILLÉ DE MODES DE RÉALISATION PARTICULIERS

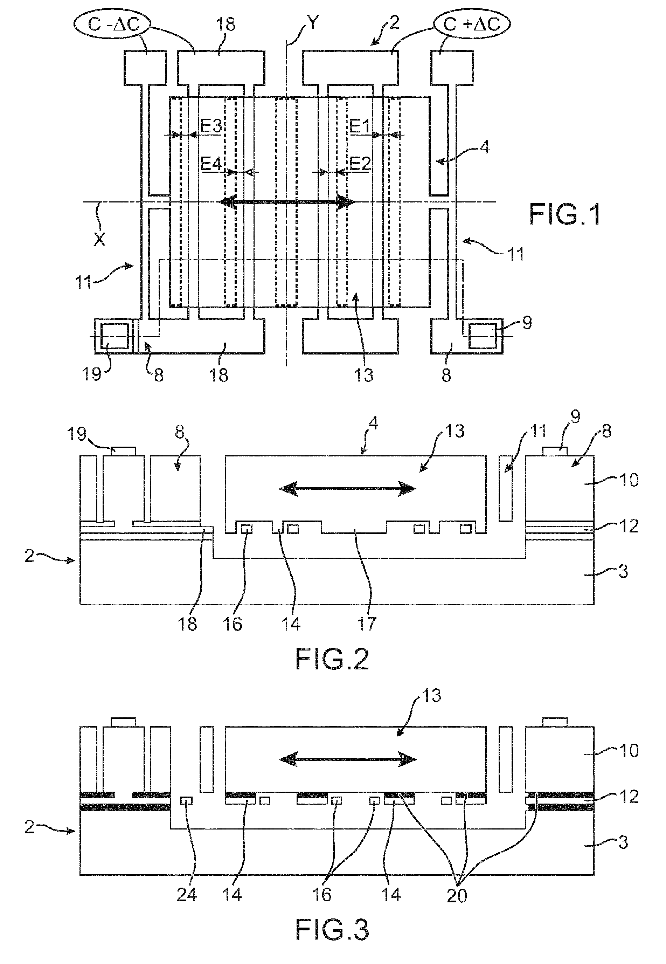

Sur les figures 1 et 2, on peut voir un exemple de réalisation d'un dispositif micro et/ou nanoélectronique à élément mobile dans lequel une variation de capacité est mesurée. A des fins de simplicité, celui-ci sera désigné uniquement par dispositif capacitif dans la suite de la description. Par ailleurs, dans la description qui va suivre les électrodes fixes ou mobiles sont utilisées à des fins de mesure du déplacement de l'élément mobile, elles seront alors désignées électrodes de détection, mais comme cela sera décrit par la suite, elles peuvent servir à actionner à l'élément mobile, i.e. à la mettre en mouvement et/ou à lui faire prendre une position donnée.

Dans l'exemple des figures 1 et 2, le dispositif capacitif comporte une partie fixe 2 et une partie mobile 4. La partie mobile 4 est apte à se déplacer par rapport à la partie fixe 2 le long d'une direction longitudinale X.

La partie fixe 2 comporte un support 3 par exemple formé à partir d'un substrat semi-conducteur, par exemple en silicium et des électrodes de détection 16 suspendues de manière fixes sur le support. Les électrodes de détection fixes 16 sont, dans l'exemple représenté, sous forme de poutres droites et s'étendent dans une direction Y perpendiculaire à la direction de déplacement X et sont suspendues de manière fixe sur le support 3 au niveau de leurs extrémités longitudinales par des zones d'ancrage 18. Les zones d'ancrage 18 se trouvent, dans l'exemple représenté, en dehors de la zone couverte par la partie mobile, mais l'une ou les deux zones d'ancrage pourraient se situer sous la partie mobile 4.

La partie mobile 4 est suspendue par rapport à la partie fixe 2 par des moyens élastiques de rappel 11, tels que deux poutre souples en flexion ancrées sur le substrat par deux plots d'ancrage 8 disposées de part et d'autre de la partie mobile 4 et permettant un déplacement de la partie mobile 4 le long de la direction longitudinale X. La forme des moyens élastiques n'est en aucun cas limitative. En outre, la partie mobile 4 pourrait se déplacer le long de plusieurs directions suivant l'application.

La partie mobile 4 comporte une première couche 10 et une deuxième couche 12. Dans l'exemple représenté et de manière très avantageuse, la première couche présente une épaisseur relativement plus grande que celle de la deuxième couche 12. Un élément mobile 13 est réalisé dans la couche 10, en présentant une épaisseur suffisante pour avoir la fonction de masse inertielle et les moyens élastiques 11 sont formés dans cette couche 10. La deuxième couche 12 relativement fine par rapport à la première couche est structurée de sorte à former des électrodes de détection mobiles 14. Dans l'exemple représenté, la deuxième couche 12 se trouve entre le support 3 et l'élément mobile 13, mais comme nous le verrons par la suite, la disposition inverse ne sort pas du cadre de la présente invention.

L'épaisseur 10 peut être comprise entre quelques dizaines de µm et quelques centaines de µm. L'épaisseur 12 peut être comprise entre quelques µm et quelques dizaines de µm. Le rapport entre l'épaisseur de la couche 10 et de la couche 12 peut être compris entre 1 et 30.

De manière avantageuse, le rapport est supérieur ou égal à 2, de sorte à avoir une couche 12 fine permettant une certaine finesse de gravure et une couche 10 épaisse pour former une masse.

Dans certaines applications, le rapport peut être de l'ordre de 20 ou 30 par exemple, ce qui permet de conserver un élément mobile formant la masse inertielle et d'avoir de manière très avantageuse une couche 12 fine permettant des gravures fines. Dans d'autres applications, les épaisseurs des deux couches sont proches, le rapport est de l'ordre de 1. La couche 12 dans laquelle les électrodes sont formées participe alors à la masse inertielle. Cette réalisation offre également une compacité augmentée car les électrodes peuvent être disposées partout sous l'élément mobile et non juste en périphérie.

Selon l'invention, puisque les moyens de suspension sont réalisés dans la couche épaisse 10, leur rigidité limite les déplacements hors-plan de la partie mobile tout en gardant une souplesse appropriée, dans le cas de mouvement de la partie mobile dans le plan, en jouant sur le facteur de forme. Par exemple, les moyens de suspension ressemblent à une lame ou des lames en série.

La couche 10 est avantageusement en matériau monocristallin, les moyens de suspension présentent alors un comportement prédictible et linéaire. En outre, le fait d'usiner les moyens de suspension dans la même couche que l'élément mobile permet de réaliser la couche d'électrodes en silicium polycristallin. Ce procédé de fabrication présente un coût sensiblement réduit par rapport à ceux de l'état de la technique, puisqu'il requiert moins de substrat et qu'aucun substrat SOI n'est utilisé.

Les électrodes de détection mobiles 14 présentent également une forme de poutre rectiligne s'étendant le long de la direction Y.

Les électrodes de détection mobiles 14 et fixes 16 sont disposées les unes par rapport aux autres de sorte qu'un flanc latéral d'une électrode fixe soit en regard d'un flanc latéral d'une électrode mobile. Le flanc latéral d'une électrode fixe et le flanc latéral d'une électrode mobile définissent entre eux un entrefer d'épaisseur variable.

Le dispositif comporte également au moins un contact électrique 9 pour polariser les électrodes de détection mobiles 14 et au moins un contact électrique 19 pour polariser les électrodes de détection fixes 16.

Dans l'exemple représenté, l'élément mobile 13 présente une surépaisseur 17 dans une zone centrale de sa face inférieure, permettant d'augmenter la masse de l'élément mobile en utilisant les zones où il n'y a pas d'électrode.

A titre d'exemple, la première couche 10 a une épaisseur comprise entre quelques dizaines et quelques centaines de microns, par exemple 60 µm, et la deuxième couche 12 a une épaisseur comprise entre quelques microns et quelques dizaines de microns, par exemple 8 µm.

L'épaisseur de l'entrefer est par exemple comprise entre 250 nm à quelques microns, par exemple égale à 400 nm.

Sur la figure 1, un exemple de configuration électrique est schématisé assurant une mesure différentielle de la variation de capacité.

Dans l'exemple représenté, le dispositif comporte quatre électrodes de détection mobiles 14 et quatre électrodes de détection fixes 16, formant par paire quatre entrefers dont on mesure la variation. Dans l'exemple représenté, les deux entrefers désignés E1 et E2, situés à droite dans la représentation de la figure 1, varient dans le même sens, augmentant ou diminuant en même temps les deux entrefers désignés E3 et E4, situés à gauche dans la représentation de la figure 1, varient dans le même sens, diminuant ou augmentant en même temps, mais dans un sens opposé au sens de variation des entrefers E1 et E2. Ces variations dans des sens différents sont représentées en désignant la capacité des entrefers E1 et E2 par C + ΔC et en désignant la capacité des entrefers E3 et E4 par C - ΔC.

La différence des mesures sur les entrefers E1 et E3 par exemple est égale à 2ΔC.

Il est à noter que les électrodes fixes et les électrodes mobiles pourraient être disposées les unes par rapport aux autres de sorte que tous les entrefers varient dans le même sens.

Sur la figure 3, on peut voir une variante de réalisation du dispositif des figures 1 et 2 dans laquelle les électrodes de détection mobiles 14 sont isolées électriquement par rapport à l'élément mobile. Pour cela une couche 20 en matériau isolant électrique, par exemple en SiO₂ est interposée entre la couche de l'élément mobile et la couche des électrodes de détection mobiles 14. Afin de pouvoir relier électriquement les électrodes de détection mobiles 14 une liaison électrique 24 est prévue entre les électrodes de détection mobiles 14 et un plot de contact sur le substrat. La liaison électrique est déformable élastiquement pour suivre les déplacements des électrodes de détection mobiles 14. Il pourrait être prévu plusieurs liaisons électriques pour relier séparément les électrodes mobiles. Plusieurs liaisons électriques pourraient également être prévues pour relier séparément les électrodes fixes.

Il est alors possible de polariser différemment les différentes électrodes mobiles et/ou les différentes électrodes fixes. Ceci est particulièrement avantageux dans les systèmes où des électrodes servent à mesurer le déplacement de la masse, et d'autres électrodes servent à entraîner l'élément mobile en mouvement. En polarisant différemment ces électrodes, on dispose de degrés de liberté supplémentaires.

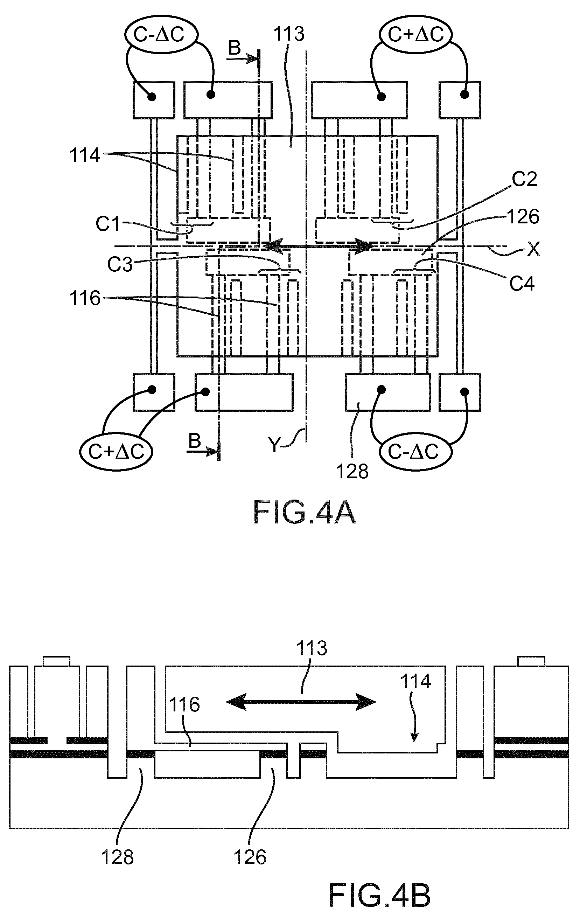

Sur les figures 4A et 4B, on peut voir un autre exemple de réalisation d'un dispositif capacitif selon l'invention. Dans cet exemple, une mesure différentielle peut également être réalisée.

Le dispositif capacitif comporte des électrodes de détection mobiles 114 s'étendant sur une partie seulement de l'élément mobile 113 dans la direction Y. Il comporte alors quatre paires d'électrodes mobiles 114. Ainsi, la longueur des électrodes fixes suspendues est réduite, elles offrent donc une plus grande rigidité. A rigidité, et donc déformation, constantes, il est alors possible de réduire la section des doigts formant les électrodes, d'augmenter leur nombre et, ainsi d'augmenter la densité de la capacité.

Les électrodes de détection fixes 116 sont, quant à elles suspendues, entre une zone 126 du substrat située en dessous de l'élément mobile et une zone 128 située en dehors de la zone couverte par l'élément mobile (figure 4B). Les électrodes fixes sont réparties par paire et les électrodes de chaque paire partage les mêmes zones de suspension. Chaque paire d'électrodes fixes est associée à une paire d'électrodes mobiles.

Dans l'exemple représenté sur la figure 4A, une configuration électrique est schématisée. Les paires d'électrodes fixes et mobiles associées forment des paires de condensateurs à capacité variables par variation d'entrefer. Ces paires sont désignées par C1, C2, C3 et C4.

Les condensateurs C1 et C4 varient dans le même sens et les condensateurs C2 et C3 varient dans le même sens, opposé au sens de variation des condensateurs C1 et C4, ceci est symbolisé par C + ΔC et C - ΔC. Il sera compris que cette disposition des condensateurs n'est pas limitative, et que l'on aurait pu prévoir par exemple que les condensateurs C1 et C3 varient dans le même sens et les condensateurs C2 et C4 varient dans le même sens en disposant les électrodes de manière adaptée.

En variante, tous les condensateurs pourraient varier dans le même sens, il ne s'agirait alors plus d'un dispositif à détection capacitive différentielle.

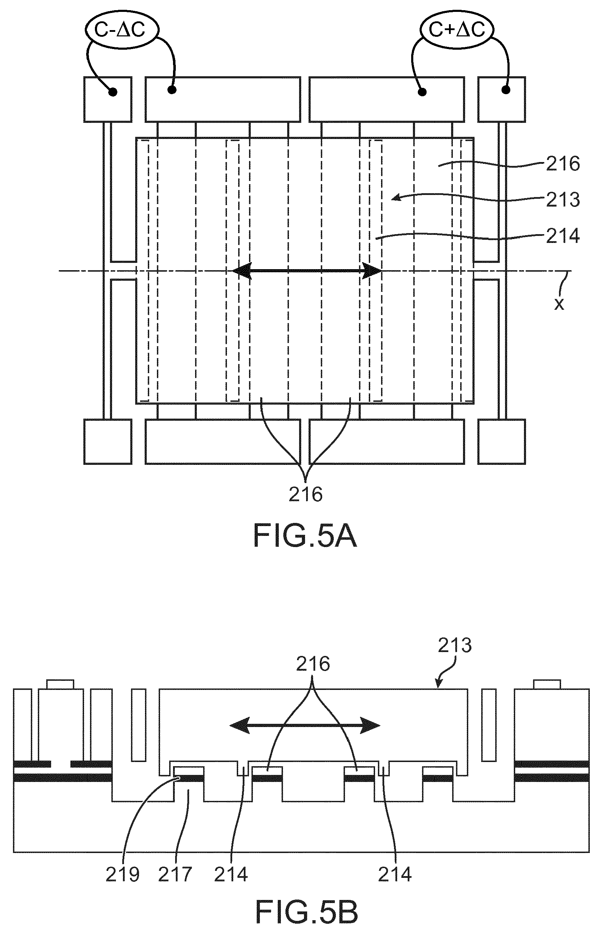

Sur les figures 5A et 5B, on peut voir un autre exemple de réalisation dans lequel les électrodes fixes sont ancrées sur le substrat. La rigidité des électrodes est encore augmentée, ce qui peut être intéressant dans le cas de forces électrostatiques importantes.

Les électrodes de détection fixes 216 s'étendent sous l'élément mobile 213 et sont solidaires sur toute leur longueur du support dans la zone du support couverte par la partie mobile. Dans l'exemple représenté, les électrodes fixes sont plus larges que les électrodes mobiles, ceci est dû au procédé de réalisation, dans lequel Le support et les électrodes fixes sont réalisés dans deux substrats différents. Lors de la fabrication, ces deux substrats vont être alignés et posés l'un sur l'autre. La taille des électrodes fixes permet de tenir compte de l'imprécision lors de l'assemblage et d'offrir une surface d'assemblage suffisante. Avec un autre procédé de réalisation, les électrodes fixes et les électrodes mobiles pourraient avoir la même largeur.

Les électrodes fixes 216 sont réalisées dans la même couche que les électrodes de détection mobiles 214. Les électrodes fixes sont supportées par des éléments en saillie 217 du support qui sont gravés dans celui-ci.

Les électrodes fixes 216 sont isolées des éléments en saillie 217 du support par une couche diélectrique 219.

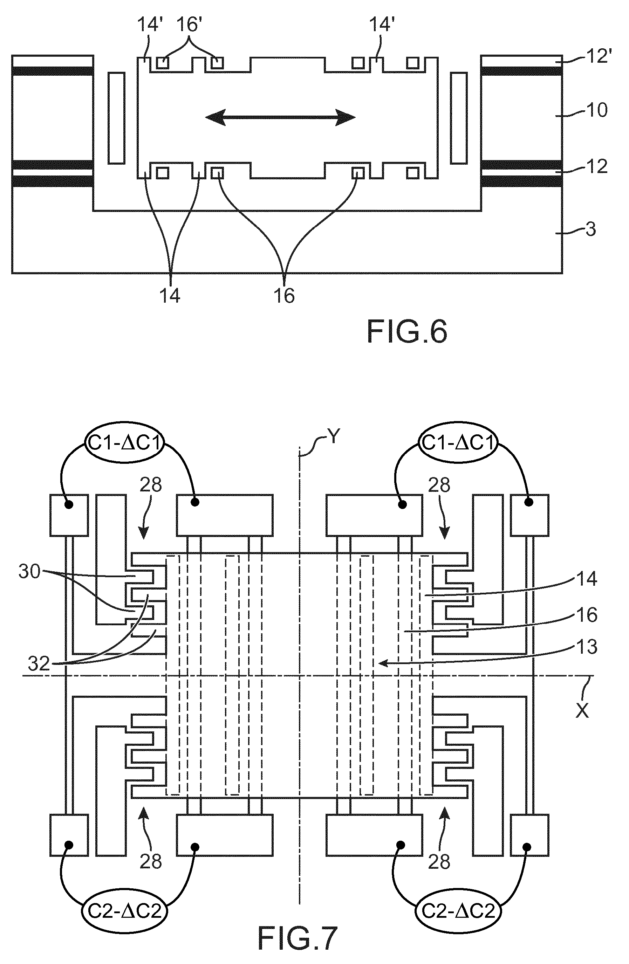

Sur la figure 6, on peut voir une variante de réalisation du dispositif des figures 1 et 2 dans laquelle des électrodes de détection mobiles sont prévues à la fois sur la face inférieure et sur la face supérieure de la partie mobile.

Les électrodes mobiles de détection 14' sont réalisées dans une couche différente de celle dans laquelle l'élément mobile 13 est réalisé. Des électrodes de détection fixes 16' sont également prévues en regard des électrodes de détection mobiles 14', les électrodes 16' sont réalisées dans la même couche 12' que les électrodes 14'. Grâce à cette réalisation, le nombre de condensateurs à capacité variable est doublé sans augmenter l'empreinte du dispositif dans le plan.

Sur la figure 7, on peut voir un autre exemple de réalisation d'un dispositif capacitif selon l'invention comportant des moyens capacitifs à la fois sous l'élément mobile et sur le ou les côtés de l'élément mobile.

Dans l'exemple représenté, la partie mobile a une structure similaire à celle de la figure 1 et comporte des moyens capacitifs latéraux 28 de type à variation d'entrefer. Ils comportent des électrodes fixes 30 solidaires du substrat et des électrodes mobiles 32 d'un seul tenant avec l'élément mobile 13 et en saillie latéralement des bords de l'élément mobile. Dans cet exemple, l'élément mobile est de forme parallélépipédique. Les électrodes mobiles s'étendent latéralement sur deux bords opposés de l'élément mobile 13. Les électrodes mobiles 32 sont d'un seul tenant avec l'élément mobile 13. Les électrodes mobiles 32 et les électrodes fixes 30 sont interdigitées. Les électrodes sont disposées de sorte que la direction de variation de surface soit parallèle à la variation d'entrefer entre les électrodes 14 et 16. Dans l'exemple représenté les électrodes 30, 32 à variation de surface peuvent permettre de « compléter » la détection obtenue grâce aux électrodes 14, 16 ou d'asservir l'élément mobile en position.

En utilisant un cadre de découplage pour donner un second degré de liberté bien connu dans les gyromètres et par exemple décrit dans *"*Micromachined gyroscope concept allowing interchangeable operation in both robust and precision modes". Adam R. Schofield & Al., Sensors and Actuators A 165 (2011), pp 35-42*),* ces moyens capacitifs latéraux 28 peuvent servir à exciter la structure, par exemple pour mettre en vibration l'élément mobile dans le cas d'un gyromètre où l'excitation se fait dans une direction orthogonale à celle de détection, et les électrodes 14 et 16 peuvent servir à la détection. Il est possible que les électrodes 14 et 16 servent à l'excitation et les moyens capacitifs latéraux servent à la détection.

En variante, ces moyens capacitifs supplémentaires peuvent servir à l'asservissement en position de l'élément mobile, du contrôle de la raideur négative, à une détection supplémentaire du déplacement de l'élément mobile...

Les moyens capacitifs supplémentaires peuvent être disposés par rapport aux électrodes 14 et 16 de sorte que leurs entrefers varient simultanément lorsque l'élément mobile se déplace.

Cette structure présente une empreinte dans le plan plus faible que celle des structures comportant à la fois des moyens de détection et d'excitation latéraux.

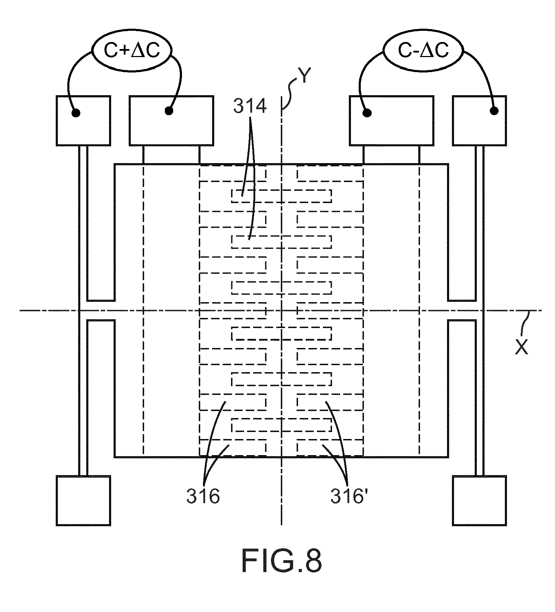

Sur la figure 8, on peut voir un autre exemple de réalisation de dispositif capacitif selon l'invention dans lequel les moyens capacitifs sont du type à variation de surface.

Les électrodes de détection fixes 316 et mobiles 314 sont parallèles à la direction de déplacement de l'élément mobile pour former des capacités à variation de surface.

Dans l'exemple représenté, la partie mobile comporte des électrodes mobiles 314 disposées parallèlement les uns aux autre dans la zone centrale de la partie mobile et interdigitées avec deux peignes d'électrodes fixes 316, 316' se faisant face. Dans cet exemple, les peignes d'électrodes fixes 316, 316' sont ancrés sur le substrat, comme dans l'exemple des figures 5A et 5B.

La mesure des capacités entre les électrodes mobiles 314 et les peignes 316, 316' permet un mesure différentielle, puisque, lorsque la capacité augmente entre le peigne 316 et les électrodes mobiles 314, celle entre le peigne 316' et les électrodes mobiles 314 diminue, ce qui est symbolisé par C + ΔC et C - ΔC.

Les fonctionnements des différents exemples et différentes variantes sont similaires. Lorsque l'élément mobile dans le cas d'un accéléromètre, d'un géophone ou d'un gyromètre par exemple est mis en mouvement sous l'effet d'une excitation extérieure, telles que l'accélération, la vibration, la vitesse de rotation,...celui-ci tend à diminuer ou augmenter l'entrefer ou la surface de recouvrement des électrodes fixes et des électrodes mobiles. Cette variation d'entrefer ou de surface se traduit par une variation de capacité qui est fonction du déplacement de l'élément mobile.

Les dispositifs peuvent fonctionner en boucle ouverte ou en boucle fermée de préférence.

Il est possible d'appliquer un mode de fonctionnement mettant en oeuvre une raideur négative électrostatique entre la partie fixe et la partie mobile. Cette raideur est contrôlée par une polarisation entre les peignes fixes et les peignes mobiles.

Dans le cas de la figure 7, cette raideur négative peut s'appliquer aussi bien sur les peignes situées sur ou sous l'élément mobile que sur les moyens supplémentaires.

Les exemples de réalisation et variantes peuvent être combinés, par exemple il est possible de combiner le dispositif de la figure 6 et celui de la figure 7, ou encore de remplacer les dispositifs à variation d'entrefer de la figure 7 par ceux à variation de surface de la figure 8 ou ceux des figures 4A, 4B ou encore ceux des figures 5A, 5B, ou encore il est possible d'avoir un dispositif de la figure 8 avec des moyens capacitifs sur et sous l'élément mobile comme c'est le cas sur la figure 6.

Grâce à l'invention, le dispositif capacitif peut présenter une très grande compacité tout en offrant une bonne sensibilité, puisqu'il est possible d'avoir un élément mobile épais tout en conservant des entrefers fins. En effet, l'épaisseur de l'entrefer entre les électrodes mobiles et les électrodes fixes situées sur ou sous l'élément mobile peut être fixée par gravure dans le cas des peignes interdigités, les électrodes fixes et mobiles étant issues de la même couche qui est une couche pouvant être plus fine relativement à celle nécessaire pour réaliser l'élément mobile. Cette épaisseur peut être fixée précisément et être relativement faible.

En outre, grâce aux entrefers fins, il est possible de densifier le nombre d'électrodes et donc d'accroître encore la sensibilité. L'invention permet donc de miniaturiser les dispositifs à capacitifs sans dégrader leurs performances, ce qui permet de réduire le coût de tels dispositifs.

La réalisation par gravure permet en outre d'avoir une bonne reproductibilité et donc d'avoir un bon rendement de fabrication.

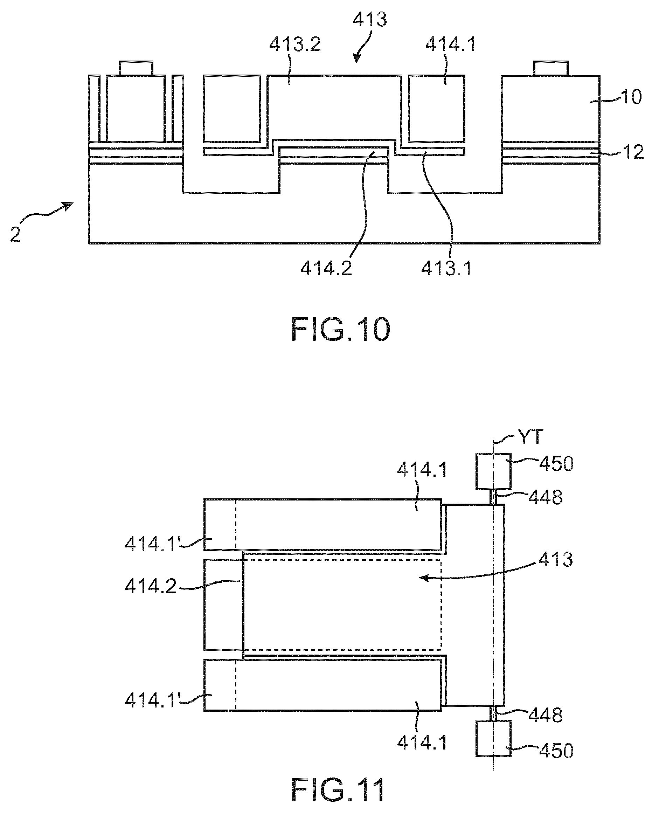

Sur la figure 10, on peut voir un exemple de réalisation d'un dispositif à détection hors plan.

Les électrodes fixes sont destinées à détecter un mouvement hors-plan de l'élément mobile. Elles sont composées d'électrodes supérieures 414.1 situées au dessus de l'élément mobile 413et au moins une électrode inférieure 414.2 situées en dessous de l'élément mobile 413. Dans l'exemple représenté, l'élément mobile a, vu en coupe, la forme d'un chapeau. Le rebord latéral 413.1 est disposé sous les électrodes fixes supérieures 414.1 et la partie centrale 413.2 est disposée au dessus de l'électrode fixe inférieure 414.2.

L'entrefer est fixé par une couche sacrificielle. Les électrodes fixes et mobiles sont réalisées en partie dans la couche 12 et en partie dans la couche 10.

La figure 11 représente une vue de dessus d'un dispositif à détection hors plan dans lequel l'élément mobile est suspendu à la partie fixe par un axe de torsion YT. L'axe de torsion est formé par deux poutres 448 alignées s'étendant de deux faces opposées de l'élément mobile, les poutres étant reliées à des plots d'ancrage 450. Les poutres sont sollicitées en torsion. Les électrodes fixes supérieures 414.1 sont ancrées par une extrémité longitudinale 414.1' à la partie fixe. En variante, les électrodes fixes supérieures 414.1 pourraient être ancrées sur le substrat sur toute leur longueur. Pour cela, elles pourraient s'étendre au-delà des bords de la masse mobile pour prendre appui sur le substrat sur lequel est directement fixée l'électrode fixe inférieure 414.2. Les électrodes fixes supérieures présenteraient une plus grande rigidité. L'élément mobile peut donc pivoter autour de l'axe YT. Les poutres 448 forment des ressorts de rappel en torsion.

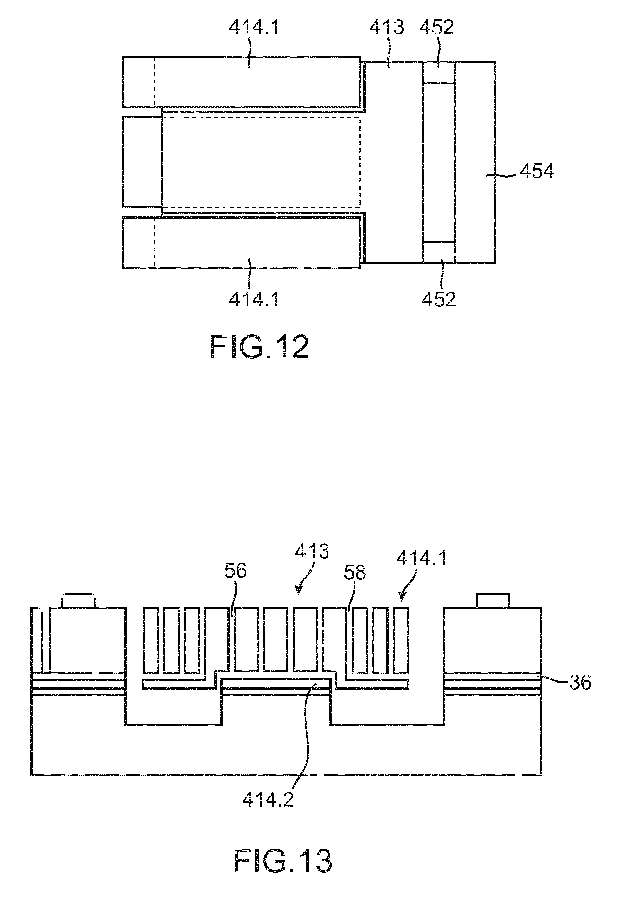

La figure 12 représente une vue de dessus d'un dispositif à détection hors plan dans lequel l'élément mobile est suspendu à la partie fixe par des poutres de flexion 452. Les deux poutres 452 s'étendent d'une face de l'élément mobile, les poutres étant reliées un plot d'ancrage 454. Les poutres 452 sont sollicitées en flexion et définissent un axe YF autour duquel l'élément mobile pivote. Les poutres 452 forment des ressorts de rappel en flexion.

Les réalisations des figures 10 à 12 permettent une mesure différentielle du déplacement de l'élément mobile.

En variante, on pourrait envisager que l'élément mobile ait à la fois un déplacement dans le plan et un déplacement hors plan en mettant en oeuvre un cadre de découplage.

En outre, les électrodes décrites ont une forme rectiligne, mais celle-ci n'est en aucun cas limitative et toute autre forme d'électrodes, par exemple courbe, ne sort pas du cadre de la présente invention. De plus, les électrodes dans le cas d'une détection par variation d'entrefer ne sont pas nécessairement perpendiculaires à la direction de déplacement de la partie mobile, mais pourrait être inclinées par rapport à celle-ci.

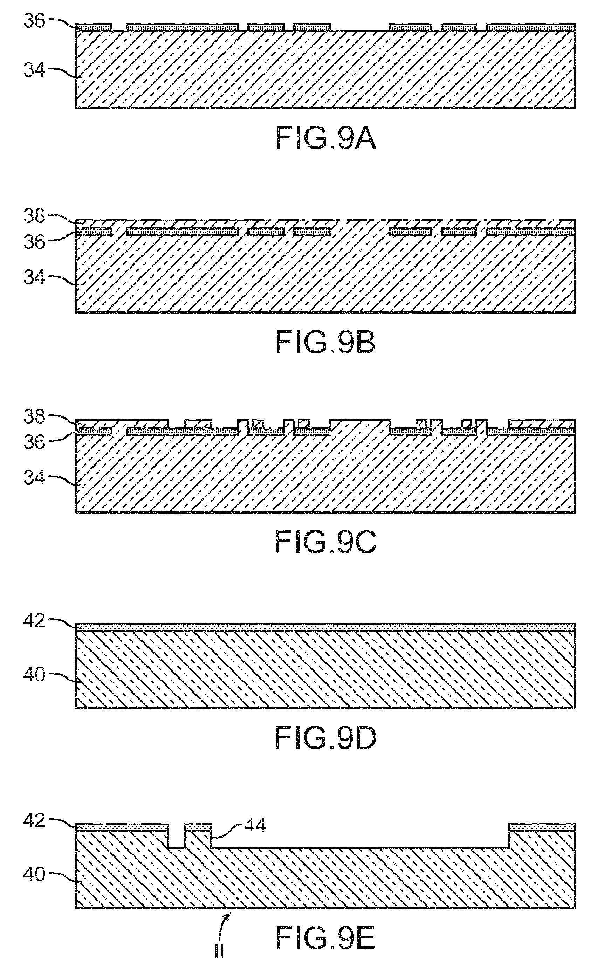

Un exemple de procédé de réalisation va maintenant être décrit à l'aide des figures 9A à 9H.

Par exemple, on part d'un premier substrat 34 de préférence semi-conducteur, par exemple en silicium. Le substrat 34 a par exemple une épaisseur 750 µm. Celui-ci est destiné à la réalisation de la partie mobile.

Lors d'une première étape, une couche sacrificielle 36 est formée sur le substrat, par exemple en oxyde. Cette couche peut être obtenue par oxydation thermique. La couche sacrificielle a par exemple une épaisseur de 1,5 µm.

La couche sacrificielle 36 est ensuite structurée par exemple par lithographie et par gravure pour ouvrir des zones de silicium qui permettront une reprise de contact avec la couche déposée ou épitaxiée suivante.

L'élément ainsi obtenu est représenté sur la figure 9A.

Lors d'une étape suivante, un couche de semi-conducteur par exemple de silicium polycristallin ou cristallin 38 est formée sur la couche sacrificielle 36 structurée. Elle est par exemple réalisée par épitaxie de silicium. Elle a par exemple une épaisseur comprise entre quelques µm et quelques dizaines de µm.

L'élément ainsi obtenu est représenté sur la figure 9B.

Lors d'une étape suivante, la couche 38 est structurée par exemple par une lithographie et ensuite gravure de la couche 38 afin de définir les électrodes de détection à la fois fixes et mobiles. La gravure s'arrête sur l'oxyde de la couche sacrificielle 36.

L'élément I ainsi obtenu est représenté sur la figure 9C.

Lors d'une étape suivante, on utilise un deuxième substrat 40 destiné à former la partie fixe.

Celui présente par exemple une épaisseur de 750 µm, il est de préférence en semi-conducteur, par exemple en silicium.

Une couche sacrificielle 42 par exemple en oxyde est formée sur l'une des faces du substrat 40. Elle a par exemple une épaisseur de 1,5 µm. Cette couche peut être obtenue par oxydation thermique...

L'élément ainsi obtenu est représenté sur la figure 9D.

Lors d'une étape suivante, le substrat 40 est structuré afin de délimiter une cavité. La structuration est par exemple réalisée par lithographie et gravure de la couche sacrificielle 42 puis du substrat 40, la gravure a lieu sur quelques µm voir quelques dizaines de µm pour définir une cavité 44 qui se trouvera sous la partie mobile dans le dispositif final.

L'élément Il ainsi obtenu est représenté sur la figure 9E.

Lors d'une étape suivante, les éléments I et II sont assemblés de sorte que la face structurée de l'élément I soit en regard de la cavité 44 de l'élément II. Les deux éléments sont par exemple assemblés, par exemple par scellement, par exemple par adhésion moléculaire.

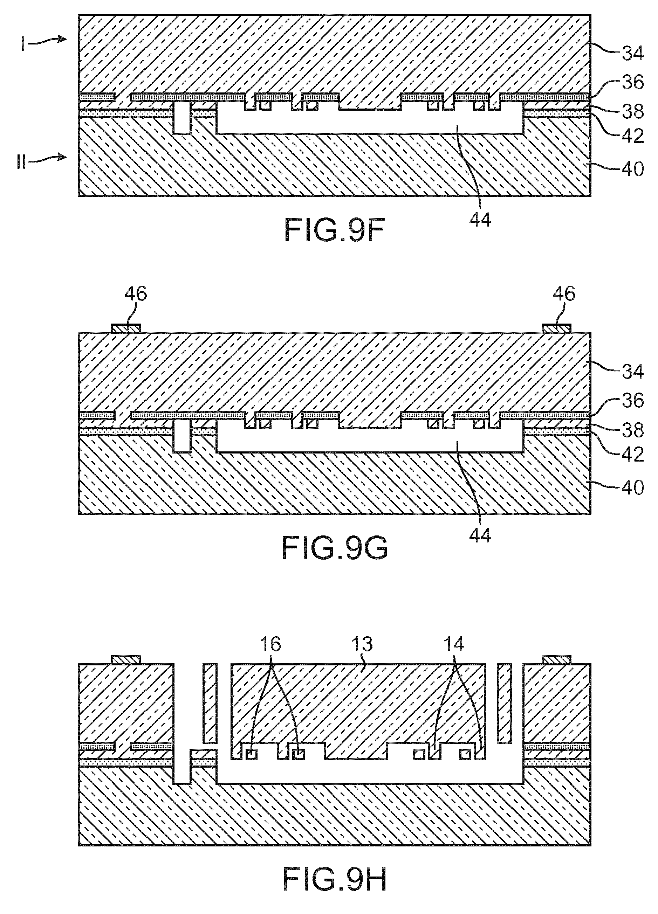

L'élément ainsi obtenu est représenté sur la figure 9F.

Lors d'une étape suivante, l'élément II est aminci par sa face avant, par exemple par gravure KOH ou par rectification mécanique ou abrasion (backgrinding en terminologie anglos-saxonne) et polissage mécano-chimique. Cet amincissement permet de définir l'épaisseur de la partie mobile qui est typiquement comprise entre quelques dizaines de µm et quelques centaines de µm.

Lors d'une étape suivante, on réalise les contacts électriques 46 sur la face avant, pour cela une couche métallique est formée en face avant, par exemple par dépôt, elle est ensuite structurée par lithographie et gravure.

L'élément ainsi obtenu est représenté sur la figure 9G.

Lors d'une étape suivante, on définit le contour de la partie mobile et les plots de contacts par lithographie.

Ensuite, le substrat 40 est gravé, par exemple par gravure profonde, par exemple par gravure ionique réactive profonde (DRIE pour Deep Reactive Ion Etching en terminologie anglo-saxonne) avec arrêt sur l'oxyde.

La partie mobile est ensuite libérée, par gravure de la couche sacrificielle 36 par exemple par acide fluorhydrique sous forme vapeur. Les électrodes fixes 16 sont également désolidarisées des électrodes mobiles 14.

L'élément ainsi obtenu est représenté sur la figure 9H.

Les électrodes fixes et mobiles ont bien été réalisées à partir de la même couche et leur entrefer a été défini par gravure.

Dans le cas où l'on souhaite isoler les électrodes mobiles de l'élément mobile (figure 3), lors de la gravure de la couche sacrificielle 26, celle-ci n'est pas gravée sur toute sa profondeur. Ainsi lors de la formation de la couche semi-conductrice 28, une couche d'oxyde subsistera entre les électrodes et la masse.

Le procédé de réalisation d'un dispositif à détection hors plan est similaire à celui décrit ci-dessus, l'entrefer étant fixé par la couche d'oxyde 36. On prévoira de ménager des trous 56 dans l'élément mobile pour assurer le retrait de la couche 36 entre l'élément mobile et les électrodes supérieures et inférieures. Des trous 58 peuvent éventuellement être réalisés dans les électrodes fixes supérieures, comme cela est représenté sur la figure 13.

Le dispositif capacitif selon l'invention peut par exemple être utilisé dans tout capteur et tout actionneur de taille micrométrique ou nanométrique utilisant des moyens de détection et/ou d'actionnement électrostatiques, tels que les accéléromètres les gyromètres, les géophones ..., en particulier ceux mettant en oeuvre des structures à peignes interdigités.

## Revendications

1. Dispositif à élément mobile (13) s'étendant suivant un plan donné comportant au moins une première (3), une deuxième (10) et une troisième (12) couches s'étendant dans des plans parallèles au plan donné, la première couche (3) formant un support, la deuxième couche (10) comportant tout ou partie de l'élément mobile (13) et des moyens de suspension (11) de l'élément mobile (13) par rapport au support, le dispositif comportant également des moyens capacitifs dont la capacité varie en fonction de la position relative de l'élément mobile (13) par rapport au support (3), lesdits moyens capacitifs comportant au moins une électrode mobile (14) solidaire d'une des faces de l'élément mobile (13) parallèle au plan donné et au moins une électrode (16) fixe par rapport au support (3), la troisième couche (12) comprenant ladite au moins une électrode fixe 16) et ladite au moins électrode mobile (14), les électrodes fixe et mobile étant disposées au moins en partie dans un même plan parallèle au plan donné et au moins en partie au-dessus et/ou en dessous de l'élément mobile (13).

2. Dispositif à élément mobile selon la revendication 1, dans lequel la deuxième couche (10) présente une épaisseur supérieure à celle de la troisième couche (12), le rapport entre l'épaisseur de la deuxième couche et celle de la troisième couche étant avantageusement au moins égal à 2, la troisième couche (12) ayant avantageusement une épaisseur comprise entre quelques µm et quelques dizaines de µm.

3. Dispositif à élément mobile selon la revendication 1 ou 2, comportant au moins deux électrodes mobiles (14) et deux électrodes fixes (16) interdigitées.

4. Dispositif à élément mobile selon l'une des revendications 1 à 3, comportant au moins deux électrodes mobiles (14) et au moins deux électrodes fixes (16) disposées de sorte que lorsque la capacité entre une électrode fixe (16) et une électrode mobile (16) augmente, la capacité entre l'autre électrode fixe (16) et l'autre électrode mobile (14) diminue afin de réaliser une mesure différentielle.

5. Dispositif à élément mobile selon l'une des revendications 1 à 4, dans laquelle l'électrode mobile (14) est isolée électriquement de l'élément mobile (13), ledit dispositif comportant des moyens de connexion électrique (24) de ladite électrode mobile (14), ledit dispositif comportant avantageusement plusieurs électrodes mobiles (14) et plusieurs électrodes fixes (16), au moins une électrode mobile (14) étant connectée électriquement de manière séparée des autres électrodes mobiles (14) et/ou au moins une électrode fixe (16) étant connectée électriquement de manière séparée des autres électrodes fixes (16).

6. Dispositif à l'élément mobile selon l'une des revendications 1 à 5, dans laquelle l'électrode fixe (16) est suspendue par rapport au support (3), l'électrode fixe étant avantageusement suspendue par rapport au support entre une zone couverte du support par l'élément mobile et une zone du support non couverte par l'élément mobile.

7. Dispositif à l'élément mobile selon l'une des revendications 1 à 5, dans laquelle l'électrode fixe est ancrée au support.

8. Dispositif à l'élément mobile selon l'une des revendications 1 à 7, comportant des moyens capacitifs supplémentaires (28) dont la capacité varie en fonction de la position relative de l'élément mobile (13) et du support (3), lesdits moyens capacitifs supplémentaires (28) étant disposés d'une part dans la deuxième couche (10) sur au moins une première zone latérale de l'élément mobile (13) et d'autre part sur une zone du support (3) en regard, les moyens capacitifs supplémentaires étant avantageusement disposés d'une part dans la deuxième couche (10) sur une deuxième zone latérale de l'élément mobile (13) opposée à la première zone et d'autre part sur une zone du support (3) en regard de la deuxième zone latérale.

9. Dispositif à élément mobile selon la revendication 8, dans lequel la capacité des moyens capacitifs varie lorsque l'élément mobile (13) se déplace selon une première direction (X) et les moyens capacitifs supplémentaires (28) sont disposés de sorte que leur capacité varie lorsque l'élément mobile (13) se déplace selon une deuxième direction différente (Y) de la première direction (X), de préférence la deuxième direction (Y) étant orthogonale à la première direction (X).

10. Dispositif à élément mobile selon l'une des revendications 1 à 9, dans lequel les moyens capacitifs sont des moyens de détection de la position relative de la partie mobile et de la partie fixe.

11. Dispositif à élément mobile selon la revendication 8 ou 9, dans lequel les moyens capacitifs et les moyens capacitifs supplémentaires (28) sont des moyens de détection de la position relative de l'élément mobile (13) et du support (3), ou des moyens parmi les moyens capacitifs et les moyens capacitifs supplémentaires (28) sont des moyens de détection de la position relative de l'élément mobile (13) et du support (3) et les autres moyens sont soit des moyens d'actionnement de l'élément mobile (13) par rapport au support (3) soit des moyens pour générer une raideur électrostatique négative sur le dispositif.

12. Système micro et/ou nanoélectronique comportant au moins un dispositif à élément mobile selon l'une des revendications 1 à 11.

13. Procédé de réalisation d'un dispositif à élément mobile selon l'une des revendications 1 à 11, comportant les étapes :
A) Structuration d'une couche conductrice ou semi-conductrice (38) formée sur un premier substrat (34) de sorte à former simultanément au moins une électrode mobile et au moins une électrode fixe,
B) Assemblage du premier substrat (34) et d'un deuxième substrat (40),
C) Structuration du premier substrat (34) afin de définir l'élément mobile et les moyens de suspension,
D) Libération de l'élément mobile et libération de l'électrode fixe par rapport l'électrode mobile.

14. Procédé selon la revendication 13, comportant préalablement à l'étape A) :
- la formation d'une couche sacrificielle (36) sur le premier substrat,
- la structuration de la couche sacrificielle (36),
- la formation de la couche conductrice ou semi-conductrice (38) sur ladite couche sacrificielle structurée (36).

15. Procédé de réalisation selon la revendication 13 ou 14, dans lequel l'étape B) est une étape de scellement par exemple par adhésion moléculaire et/ou dans lequel l'étape D) a lieu par retrait au moins partielle de la couche sacrificielle, par exemple par gravure.

## Patentansprüche

1. Gerät mit beweglichem Element (13), das sich entlang einer gegebenen Ebene erstreckt, umfassend wenigstens eine erste (3), eine zweite (10) und eine dritte (12) Schicht, die sich in Ebenen parallel zur gegebenen Ebene erstrecken, wobei die erste Schicht (3) einen Träger bildet, wobei die zweite Schicht (10) das gesamte bewegliche Element (13) oder einen Teil davon sowie Mittel zur Aufhängung (11) des beweglichen Elements (13) bezüglich des Trägers umfasst, wobei die Vorrichtung ferner kapazitive Mittel umfasst, deren Kapazität als Funktion der Relativposition des beweglichen Elements (13) bezüglich des Trägers (3) variiert, wobei die kapazitiven Mittel wenigstens eine bewegliche Elektrode (14) umfassen, die mit einer der Flächen des beweglichen Elements (13) parallel zur gegebenen Ebene verbunden ist, sowie wenigstens eine bezüglich des Trägers (3) feste Elektrode (16), wobei die dritte Schicht (12) die wenigstens eine feste Elektrode (16) und die wenigstens eine bewegliche Elektrode (14) umfasst, wobei die feste und die bewegliche Elektrode wenigstens teilweise in ein und derselben Ebene parallel zur gegebenen Ebene und wenigstens teilweise über und/oder unter dem beweglichen Element (13) angeordnet sind.

2. Gerät mit beweglichem Element nach Anspruch 1, wobei die zweite Schicht (10) eine Dicke größer als jene der dritten Schicht (12) aufweist, wobei das Verhältnis zwischen der Dicke der zweiten Schicht und jener der dritten Schicht vorzugsweise wenigstens gleich 2 ist, wobei die dritte Schicht (12) vorzugsweise eine Dicke aufweist, die zwischen einigen µm und einigen zehn µm enthalten ist.

3. Gerät mit beweglichem Element nach Anspruch 1 oder 2, umfassend wenigstens zwei bewegliche Elektroden (14) und zwei feste Elektroden (16), die interdigital sind.

4. Gerät mit beweglichem Element nach einem der Ansprüche 1 bis 3, umfassend wenigstens zwei bewegliche Elektroden (14) und wenigstens zwei feste Elektroden (16), die derart angeordnet sind, dass dann, wenn die Kapazität zwischen einer festen Elektrode (16) und einer beweglichen Elektrode (16) steigt, die Kapazität zwischen der anderen festen Elektrode (16) und der anderen beweglichen Elektrode (14) sinkt, um eine differentielle Messung zu realisieren.

5. Gerät mit beweglichem Element nach einem der Ansprüche 1 bis 4, wobei die bewegliche Elektrode (14) elektrisch von dem beweglichen Element (13) isoliert ist, wobei das Gerät Mittel (24) zur elektrischen Verbindung der beweglichen Elektrode (14) umfasst, wobei das Gerät vorzugsweise mehrere bewegliche Elektroden (14) und mehrere feste Elektroden (16) umfasst, wobei wenigstens eine bewegliche Elektrode (14) elektrisch von den anderen beweglichen Elektroden (14) separiert verbunden ist, und/oder wenigstens eine feste Elektrode (16) elektrisch von den anderen festen Elektroden (16) separiert verbunden ist.

6. Gerät mit beweglichem Element nach einem der Ansprüche 1 bis 5, wobei die feste Elektrode (16) bezüglich des Trägers (3) aufgehängt ist, wobei die feste Elektrode vorzugsweise bezüglich des Trägers zwischen einer durch das bewegliche Element bedeckten Zone des Trägers und einer durch das bewegliche Element nicht bedeckten Zone des Trägers aufgehängt ist.

7. Gerät mit beweglichem Element nach einem der Ansprüche 1 bis 5, wobei die feste Elektrode am Träger verankert ist.

8. Gerät mit beweglichem Element nach einem der Ansprüche 1 bis 7, umfassend zusätzliche kapazitive Mittel (28), deren Kapazität als Funktion der Relativposition des beweglichen Elements (13) und des Trägers (3) variiert, wobei die zusätzlichen kapazitiven Mittel (28) einerseits in der zweiten Schicht (10) auf wenigstens einer ersten lateralen Zone des beweglichen Elements (13) angeordnet sind und andererseits auf einer gegenüberliegenden Zone des Trägers (3), wobei die zusätzlichen kapazitiven Mittel vorzugsweise einerseits in der zweiten Schicht (10) auf einer zweiten lateralen Zone des beweglichen Elements (13) entgegengesetzt zur ersten Zone und andererseits auf einer Zone des Trägers (3) gegenüber der zweiten lateralen Zone angeordnet sind.

9. Gerät mit beweglichem Element nach Anspruch 8, wobei die Kapazität der kapazitiven Mittel variiert, wenn sich das bewegliche Element (13) entlang einer ersten Richtung (X) verlagert, und die zusätzlichen kapazitiven Mittel (28) derart angeordnet sind, dass ihre Kapazität variiert, wenn sich das bewegliche Element (13) entlang einer zweiten Richtung (Y) verlagert, die von der ersten Richtung (X) verschieden ist, wobei vorzugsweise die zweite Richtung (Y) orthogonal zur ersten Richtung (X) ist.

10. Gerät mit beweglichem Element nach einem der Ansprüche 1 bis 9, wobei die kapazitiven Mittel Mittel zur Erfassung der Relativposition des beweglichen Teils und des festen Teils sind.

11. Gerät mit beweglichem Element nach Anspruch 8 oder 9, wobei die kapazitiven Mittel und die zusätzlichen kapazitiven Mittel (28) Mittel zur Erfassung der Relativposition des beweglichen Elements (13) und des Trägers (3) sind, oder wobei Mittel aus den kapazitiven Mitteln und den zusätzlichen kapazitiven Mitteln (28) Mittel zur Erfassung der Relativposition des beweglichen Elements (13) und des Trägers (3) sind, und die anderen Mittel entweder Mittel zur Betätigung des beweglichen Elements (13) bezüglich des Trägers (3) sind, oder Mittel zur Erzeugung einer negativen elektrostatischen Steifigkeit auf dem Gerät.

12. Mikro- und/oder nanoelektronisches System, umfassend wenigstens ein Gerät mit beweglichem Element nach einem der Ansprüche 1 bis 11.

13. Verfahren zur Herstellung eines Geräts mit beweglichem Element nach einem der Ansprüche 1 bis 11, umfassend die Schritte:
A) Strukturierung einer leitenden oder halbleitenden Schicht (38), die auf einem ersten Substrat (34) gebildet ist, derart, dass gleichzeitig wenigstens eine bewegliche Elektrode und wenigstens eine feste Elektrode gebildet werden,
B) Zusammenfügen des ersten Substrats (34) und eines zweiten Substrats (40),
C) Strukturieren des ersten Substrats (34), um das bewegliche Element und die Aufhängungsmittel zu definieren,
D) Befreien des beweglichen Elements und Befreien der festen Elektrode bezüglich der beweglichen Elektrode.

14. Verfahren nach Anspruch 13, umfassend vor dem Schritt A):
- das Bilden einer Opferschicht (36) auf dem ersten Substrat,
- das Strukturieren der Opferschicht (36),
- das Bilden der leitenden oder halbleitenden Schicht (38) auf der strukturierten Opferschicht (36).

15. Verfahren zur Herstellung nach Anspruch 13 oder 14, wobei der Schritt B) ein Schritt der Versiegelung beispielsweise durch molekulare Adhäsion ist und/oder wobei der Schritt D) durch wenigstens partielles Entfernen der Opferschicht erfolgt, beispielsweise mittels Gravieren.

## Claims

1. Device with mobile element (13) extending according to a given plane comprising at least one first layer (3), one second layer (10) and one third layer (12) extending in planes parallel to the given plane, with the first layer (3) forming a support (13), the second layer (10) comprising all or a portion of the mobile element (13) and means (11) for suspending the mobile element (13) with respect to the support, the device also comprising capacitive means which the capacitance varies according to the relative position of the mobile element (13) with respect to the support (3), said capacitive means comprising at least one mobile electrode (14) secured to one of the faces of the mobile element (13) parallel to the given plane, and at least one fixed electrode (16) with respect to the support, the third layer (12)comprising said at least one fixed electrode (16) and said at least one mobile electrode (14), the fixed and mobile electrodes being arranged at least partially in the same plane parallel to the given plane and at least partially above and/or below the mobile element (13).

2. Device with mobile element according to claim 1, wherein the second layer (10) has a thickness greater than that of the third layer (12), the ratio between the thickness of the second layer and that of the third layer (13) being advantageously at least equal to 2, the third layer having advantageously a thickness between a few µm and a few tens of µm.

3. Device with mobile element according to claim 1 or 2, comprising at least two mobile electrodes (14) and two fixed electrodes(16) which are interdigitated.

4. Device with mobile element according to one of the claims 1 to 3, comprising at least two mobile electrodes (14) and at least two fixed electrodes (16) arranged in such a way that when the capacitance between a fixed electrode (16) and a mobile (16) electrode increases, the capacitance between the other fixed electrode (16) and the other mobile electrode (14) decreases in order to take a differential measurement.

5. Device with mobile element according to one of the claims 1 to 4, wherein the mobile electrode (14) is isolated electrically from the mobile element (13), said device comprising electrical connexion means (24) of said mobile electrode (14), .said device comprising advantageously several mobile electrodes (14) and several fixed electrodes (16), at least one mobile electrode (14) being connected electrically separately from the other mobile electrodes (14) and/or at least one fixed electrode (16) being connected electrically separately from the other fixed electrodes (16).

6. Device with mobile element according to one of the claims 1 to 5, wherein the fixed electrode (16) is suspended with respect to the support (3), the fixed electrode being advantageously suspended with respect to the support between a zone of the support covered by the mobile element and a zone of the support not covered by the mobile element.

7. Device with mobile element according to one of the claims 1 to 5, wherein the fixed electrode is anchored to the support.

8. Device with mobile element according one of the claims 1 to 7, comprising at least one additional capacitive means (28) of which the capacitance varies according to the relative position of the mobile element (13) and of the support (3), with said additional capacitive means (28) being arranged on the one hand in the second layer (10) on at least one first lateral zone of the mobile element (13) and on the other hand on a zone of the support (3) which faces the at least one first lateral zone of the mobile element, the additional capacitive means being advantageously arranged on the one hand in the second layer (10) on a second lateral zone of the mobile element (13) opposite the first zone and on the other hand on a zone of the support (3) facing the second lateral zone.

9. Device with mobile element according to claim 8, wherein the capacitance of the capacitive means varies when the mobile element (13) is moved according to a first direction (X) and the additional capacitive means (28) are arranged in such a way that their capacitance varies when the mobile element (13) is moved according to a second direction (Y) different from the first direction (X), more preferably the second direction (Y) being orthogonal to the first direction (X).

10. Device with mobile element according to one of the claims 1 to 9, wherein the capacitive means are a means for detecting the relative position of the mobile portion and of the fixed portion.

11. Device with mobile element according to claim 8 or 9, wherein the capacitive means and the additional capacitive means (28) are means for detecting the relative position of the mobile element (13) and of the fixe part (3) or means amongst the capacitive means and the additional capacitive means (28) are means for detecting the relative position of the mobile element (13) and of the support (3) and the other means are either an actuator for actuating the mobile element (13) with respect to the support (3)or a generator for generating a negative electrostatic stiffness on the device.

12. Micro and/or nanoelectronic system comprising at least one device with mobile element according to one of the claims 1 to 11.

13. Method for producing a device with mobile element according to one of the claims 1 to 11, comprising the steps of:
A) Structuring a conductive or semi-conductive layer (38) formed on a first substrate (34) in such a way as to form simultaneously at least one mobile electrode and at least one fixed electrode,
B) Assembling of the first substrate (34) and of a second substrate (40),
C) Structuring of the first substrate (34) in order to define the mobile element and the means of suspension,
D) Releasing of the mobile element and release of the fixed electrode with respect to the mobile electrode.

14. Method according to claim 13, comprising prior to the step A):
- forming a sacrificial layer (36) on the first substrate,
- structuring the sacrificial layer (36),
- forming the conductive or semi-conductive layer (38) on said structured sacrificial layer (36).

15. Method for realising according to claim 13 or 14, wherein the step B) is a step of sealing for example via molecular adhesion or/and wherein the step D) takes place by removing at least partially the sacrificial layer, for example via etching.
